# EUROPÄISCHE PATENTSCHRIFT

(11) **EP 0 980 090 B1**
(45) Veröffentlichungstag und Bekanntmachung des Hinweises auf die Patenterteilung: **02.05.2007**
(21) Anmeldenummer: 99114913.9
(22) Anmeldetag: 30.07.1999
(51) Int. Cl.: H01J 37/34

(54) **Zerstäubungsvorrichtung mit einer Kathode mit Permanentmagnetanordnung**
Sputtering device with a cathode comprising a permanent magnet assembly
Dispositif de pulvérisation avec une cathode comportant un assemblage d'aimants permanents

(30) Priorität: 10.08.1998 DE 19836125
(43) Veröffentlichungstag der Anmeldung: 16.02.2000
(73) Patentinhaber: Applied Materials GmbH & Co. KG, 63755 Alzenau (DE)
(72) Erfinder: Haas, Dieter, 63486 Bruchköbel (DE); Krempel-Hesse, Jörg, Dr., 63686 Eckartsborn (DE); Buschbeck, Wolfgang, Dr., 63454 Hanau (DE)
(74) Vertreter: GROSSE BOCKHORNI SCHUMACHER

(56) Entgegenhaltungen:
- EP-A- 0 337 012
- EP-A- 0 645 798
- EP-A- 0 704 878
- DE-A- 19 614 487
- PATENT ABSTRACTS OF JAPAN Bd. 009, Nr. 066 (C-271), 26. März 1985 (1985-03-26) & JP 59 200763 A (FUJITSU KK), 14. November 1984 (1984-11-14)

## Beschreibung

Die Erfindung betrifft eine Zerstäubungsvorrichtung mit magnetischer Verstärkung durch eine Permanentmagnetanordnung, die auf der von der Zerstäubungsfläche eines Targets abgewandten Seite dieses Targets angeordnet ist und ein Magnetfeld erzeugt, dessen Kraftlinien oberhalb der Zerstäubungsfläche verlaufen und diese durchdringen, mit einer Kathode, die zumindest teilweise von der Zerstäubungsfläche gebildet ist, und mit einer von der Kathode im Abstand angeordneten Anode zum Erzeugen eines elektrischen Feldes, wobei die Permanentmagnete über ein Joch aus Weicheisen verbunden sind.

Bekannt ist eine Zerstäubungsvorrichtung der in Frage stehenden Art (DE 29 20 780 C2) bei der Maßnahmen getroffen sind, die einen flachen Verlauf der Magnetfeldlinien über der Zerstäubungsfläche des Targets bewirken, wozu die Permanentmagnetanordnung aus einer Anzahl von einzelnen, aneinandergefügten Magnetelementen gebildet ist, deren Orientierung und Anordnung relativ zueinander so gewählt ist, daß die Kraftlinien des Magnetfeldes sowohl im Inneren der Magnetanordnung als auch über einen großen Teil der Zerstäubungsfläche des Targets im wesentlichen parallel zu dieser verlaufen.

Bei einer besonderen Ausführungsform dieser bekannten Zerstäubungsvorrichtung weisen die Magnetelemente einer ersten Gruppe eine geneigt zur Zerstäubungsfläche des Targets verlaufende Polungsrichtung und die Magnetelemente einer zweiten Gruppe eine zur Zerstäubungsfläche parallel verlaufende Polungsrichtung auf.

Auch die Druckschrift DE 196 14 487 A1 offenbart eine Magnetanordnung für eine Sputterkathode der genannten Art, wobei die Sputterkathode einen flachen und besonders breiten Erosionsgraben im Sputtertarget ausbilden soll, indem ein weichmagnetischer Einsatz in eine Ausnehmung der Targetgrundplatte eingesetzt wird.

Eine weitere Vorrichtung zum Sputtern offenbart die Druckschrift JP 59- 200763, bei der die Austrittsflächen der Magnetfeldlinien an den Magnetpolen schräg zur Targetvorderfläche orientiert sind, wobei diese Vorrichtung jedoch kein Joch zum Führen des magnetischen Flusses vorsieht.

Bekannt ist weiterhin eine Sputterkathode (US 4,461,688) mit einem plattenförmigen Target und mehreren, auf der dem Substrat abgewandten Seite des Targets angeordneten U-förmigen Magneteinheiten, wobei die beiden Schenkel einer ersten U-förmigen Magneteinheit mit ihren Stirnflächen an den Randpartien der abgewandten Fläche des Targets anliegen und ein weiteres Paar von U-förmigen Magneteinheiten jeweils an einer Hälfte der abgewandten Targetfläche mit den Stirnflächen ihrer Schenkel anliegen und weitere zweite Paare von kleineren U-förmigen Magneteinheiten mit den Stirnflächen ihrer beiden Schenkel jeweils an der äußeren Hälfte der vom zweiten Paar Magneteinheiten übergriffenen Partie der abgewandten Fläche des Targets anliegen.

Schließlich hat man bereits eine Zerstäubungskathode nach dem Magnetron-Prinzip vorgeschlagen (DE 198 19 785.3) mit einem aus mindestens einem Teil bestehenden Target aus dem zu zerstäubenden Material mit einem hinter dem Target angeordneten Magnetsystem mit Quellen unterschiedlicher Polung, durch die mindestens ein in sich geschlossener Tunnel aus bogenförmig gekrümmten Feldlinien gebildet wird, wobei die dem Target abgekehrten Pole der Quellen über ein Magnetjoch aus weichmagnetischem Material miteinander verbunden sind, und wobei die die Quellen der Magnetfelder bildenden Körper gerade Prismen, vorzugsweise Quader sind, deren Grundkanten parallel der Targetebene ausgerichtet sind, wobei die Feldlinien der Quellen jeweils in einem Winkel geneigt zu den Grundflächen der Körper verlaufen.

Eine weitere Ausführungsform einer Zerstäubungskathode nach dem Magnetron-Prinzip offenbart die Druckschrift EP 0 337 012 A2. Die Zerstäubungskathode sieht zwei konzentrische Plasmaringe vor, die mittels einer inneren Magnetscheibe, einem mittleren Magnetring und einem äußeren Magnetring erzeugt werden. Um die Schichtdickenverteilung auf dem Substrat zu vergleichmäßigen, offenbart die Erfindung, dass der magnetische Fluss durch das Magnetjoch von der inneren Magnetscheibe zum mittleren Magnetring verändert wird, indem das innere scheibenförmige Joch und das es umgebende ringförmige Joch an einer Schnittstelle relativ zueinander versetzt wird.

Weiterhin sei die Druckschrift EP 0 704 878 A1 genannt, die eine Vorrichtung zum Ablagern von Werkstoff mit gleichmäßiger Schichtdicke mittels Sputtern offenbart. Die Erfindung sieht vor, die Targetoberfläche nichtparallel zum Substrat anzuordnen, um den vom Target ausgehenden Strom abgetragener Teilchen relativ zum Substrat auszurichten.

Der vorliegenden Erfindung liegt die Aufgabe zugrunde, eine Zerstäubungskathode zu schaffen, deren Target eine besonders hohe Standzeit aufweist bzw. eine hohe Ausnutzung des eingesetzten Targetwerkstoffs ermöglicht, deren Magnete nicht vom Kühlmittel für die Kathode umspült sind und die sich für ein Beschichtungsverfahren mit hoher Abscheidungsrate eignet.

Diese Aufgabe wird erfindungsgemäß dadurch gelöst, daß zwischen den beiden Permantentmagnetreihen ein in seiner Konfiguration dem Joch angepaßter, im Querschnitt vorzugsweise U-förmiger Einsatz aus ferromagnetischem Werkstoff vorgesehen ist, dessen dem Target abgewandte rückseitige Fläche an der dem Target zugewandten von den beiden Permanentmagnetreihen begrenzten Fläche des Magnetjochs anliegt, wobei die beiden Schenkel des Einsatzes sich jeweils mit Abstand zu den Permanentmagnetreihen in Richtung auf das Target zu erstrecken.

Bei einer alternativen Ausführungsform ist die den Reihen von Permanentmagneten abgewandte Fläche des Targets aus zwei sich geneigt zueinander erstreckenden Teilflächen gebildet, wobei die beide Teilflächen miteinander bildende Kante parallel zu den beiden Reihen von Permanentmagneten verläuft und wobei der Einsatz aus ferromagnetischem Werkstoff zwischen dem Magnetjoch und der dem Magnetjoch zugewandten Fläche des Targets eingelegt ist.

Die Erfindung ist in den Patentansprüchen näher beschrieben und gekennzeichnet.

Die Erfindung läßt die verschiedensten Ausführungsmöglichkeiten zu; zwei davon sind in anhängenden Zeichnungen, die zwei verschiedene kreisringförmige Kathoden im Teilschnitt zeigen, rein schematisch dargestellt, wobei die Rotationsachse bzw. die Symmetrieachse mit R bezeichnet ist.

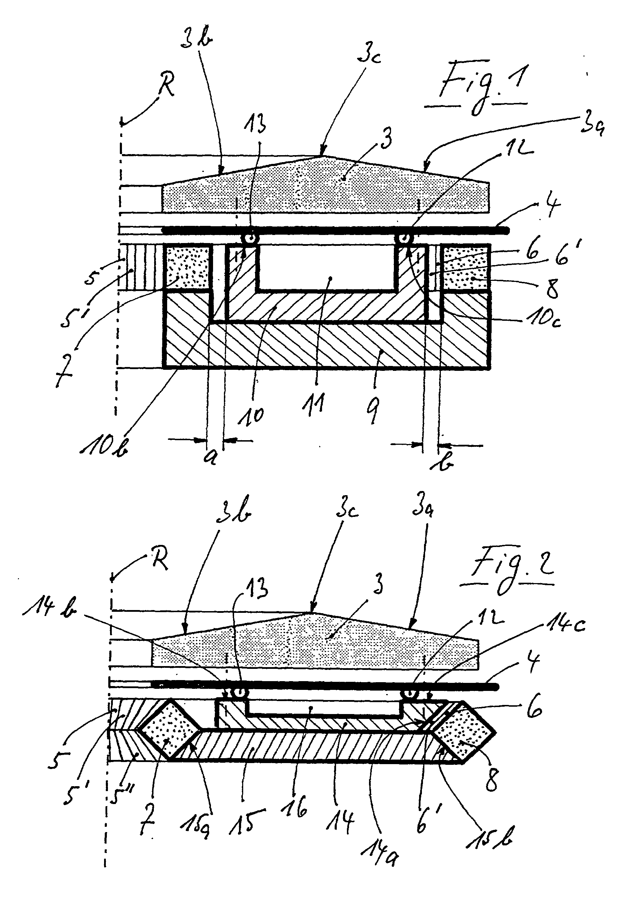

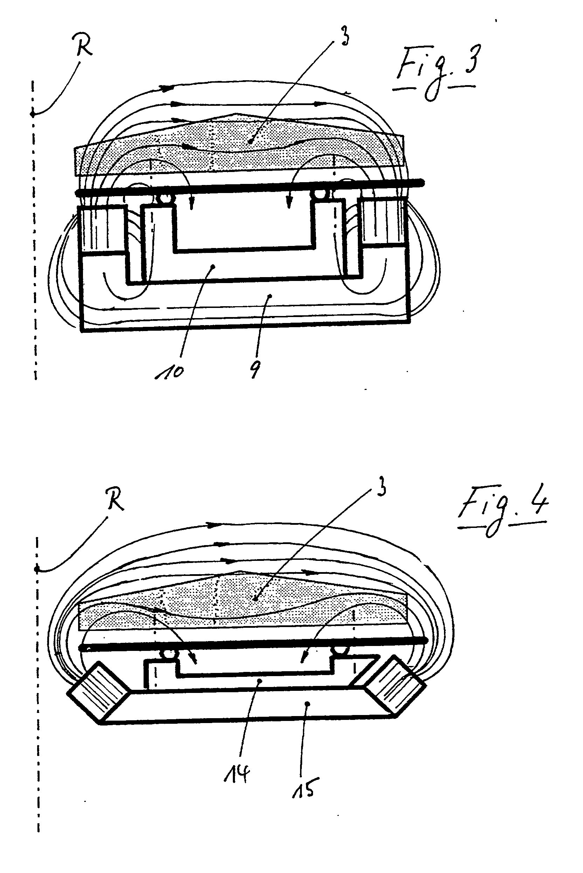

Die Figuren 3 und 4 zeigen die Kathoden gemäß den Figuren 1 und 2, jedoch stark schematisiert, wobei der Verlauf der Magnetfeldlinien angedeutet ist.

Die Kathode gemäß Fig. 1 besteht aus einem kreisringartigen Target 3 mit einer Querschnittsfläche, die von einem Fünfeck mit zwei zueinander parallelen und sich rechtwinklig zur Grundkante erstrekkenden Kanten gleicher Länge und zwei einen gestreckten Winkel miteinander einschließenden Kanten gebildet ist, einem kreisringförmigen Folienzuschnitt 4, zwei kreisringzylindrische, jeweils aus einer Vielzahl von einzelnen quaderförmigen Permanentmagneten 5, 5', ... bzw. 6, 6', ... zusammengesetzte Permanentmagnetreihen 7, 8, einem etwa kreisringzylinderförmigen im Querschnitt U-förmigen Magnetjoch 9, einem Einsatz 10 mit einem U-förmigen Querschnitt, der demjenigen des Magnetjochs 9 angeglichen ist, einen vom Folienzuschnitt 4 verschlossenen in den Einsatz 10 eingeschnittenen Kanal 11 und zwei Dichtringen 12, 13, die sicherstellen, daß das durch den Kanal 11 strömende Kühlmittel nicht in den Bereich der Kathode eindringt, in dem die Permanentmagnete 5, 5', .. bzw. 6, 6',, ... angeordnet sind.

Die beiden dem Substrat zugekehrten Teilflächen des Targets 3 sind mit 3a, 3b bezeichnet; die von beiden Teilflächen 3a, 3b gebildete gemeinsame Kante ist mit 3c gekennzeichnet. Die beiden Stirnflächen des Einsatzes 10, die gegenüber dem Folienzuschnitt 4 abgedichtet sind, sind mit 10b, 10c beziffert.

Die Kathode gemäß Fig. 2 besteht aus einem kreisringartigen Target 3, dessen Konfiguration derjenigen nach Fig. 1 entspricht, einem unterhalb des Targets 3 angeordneten kreisringförmigen Folienzuschnitt 4, zwei Dichtringen 12, 13, einem Einsatz 14 aus ferromagnetischem Werkstoff, einem Magnetjoch 15 mit einem etwa trapezförmigen Querschnitt und zwei Permantenmagnetreihen 7, 8, die jeweils aus einer Vielzahl einzelner quaderförmiger Einzelmagneten 5, 5', ... bzw. 6, 6', ... zusammengesetzt sind. Im Gegensatz zur Ausführung nach Fig. 1 sind die einzelnen würfel- oder quaderförmigen Permanentmagnete 5, 5', ... bzw. 6, 6',... bei der Kathode nach Fig. 2 in schräger Lage zur Targetebene bzw. zur Rotationsachse R angeordnet, wobei sie jeweils auf den umlaufenden abgeschrägten Seitenflächen 15a bzw. 15b des etwa kreisscheibenförmigen flachen Jochs 15 befestigt sind.

Es bleibt zu erwähnen, daß die die Quellen der Magnetfelder bildenden Körper gerade Prismen bzw. Quader 5, 5', ..., 6, 6', ... sind, deren Grundkanten geneigt bzw. im Winkel α zur Targetebene ausgerichtet sind, wobei die Feldlinien der Quellen jeweils parallel zu den Seitenkanten der Quadern 5, 5', ..., 6, 6', ... verlaufen.

Wie aus Fig. 2 ersichtlich ist, beträgt der Neigungswinkel (zur Targetebene) der quaderförmigen Permanentmagnete 5, 5', ..., 6, 6', ... etwa 45° (siehe Fig. 4)

## Patentansprüche

1. Zerstäubungsvorrichtung mit magnetischer Verstärkung durch eine Permanentmagnetanordnung, die auf der von der Zerstäubungsfläche eines Targets abgewandten Seite dieses Targets angeordnet ist und ein Magnetfeld erzeugt, dessen Kraftlinien oberhalb der Zerstäubungsfläche verlaufen und diese durchdringen, mit einer Kathode, die zumindest teilweise von der Zerstäubungsfläche gebildet ist, und mit einer vor der Kathode im Abstand angeordneten Anode zum Erzeugen eines elektrischen Feldes, wobei die Permanentmagnetanordnung aus zwei kreisförmigen oder ovalen, jeweils in sich geschlossenen und koaxial zueinander angeordneten Reihen (7, 8) von Einzelmagneten (5, 5', ... 6, 6', ...) gebildet ist, die über ein Joch (9, 15) miteinander in Verbindung stehen, wobei ein Einsatz (10, 14) aus ferromagnetischem Werkstoff vorgesehen ist, **dadurch gekennzeichnet, dass**
der Einsatz (10, 14) im Querschnitt U-förmig oder im wesentlichen U-förmig, zwischen den beiden Permanentmagnetreihen (7, 8) vorgesehen und in seiner Konfiguration dem Joch (9) angepasst ist, wobei seine dem Target (3) abgewandte rückseitige Fläche an der dem Target (3) zugewandten von den Permanentmagnetreihen (7, 8) begrenzten Fläche des Magnetjochs (9) anliegt, wobei die beiden Schenkel des Einsatzes (10, 14) sich jeweils im Abstand (a, b) zu den Permanentmagnetreihen (7, 8) in Richtung auf das Target (3) zu erstrecken.

2. Zerstäubungsvorrichtung nach dem Oberbegriff des Anspruchs 1, **dadurch gekennzeichnet, dass**
die den Reihen von Permanentmagneten (7, 8) abgewandte Fläche des Targets (3) aus zwei sich winklig zueinander erstreckenden Teilflächen (3a, 3b) gebildet ist, wobei die von beiden Teilflächen (3a, 3b) miteinander gebildete Kante (3c) parallel zu den Reihen (7, 8) der Permanentmagnete (5, 5', ... 6, 6', ...) verläuft und, wobei der Einsatz (10, 14) zwischen dem Magnetjoch (9, 15) und der dem Magnetjoch (9, 15) zugekehrten Fläche des Targets (3) eingelegt ist.

3. Zerstäubungsvorrichtung nach den Ansprüchen 1 und/oder 2, weiter **gekennzeichnet,** daß die der radial innen liegenden Permanentmagnetreihe (7) zugewandte Fläche des Einsatzes (14) sich lotrecht zur Targetebene und die der radial außen liegenden Permanentmagnetreihe (8) zugewandte Fläche des Einsatzes (14) als eine zur Ebene des Jochs (15) geneigte Fläche (14a) ausgebildet ist.

4. Zerstäubungsvorrichtung nach einem der Ansprüche 1 bis 3, weiter **gekennzeichnet,** daß die einzelnen Permanentmagnete (5, 5', ..., 6, 6', ...) der Permanentmagnetreihen (7, 8) als gerade Prismen, vorzugsweise als Würfel oder Quader ausgeformt sind, deren Grundkanten und Seitenkanten zur Targetebene geneigt verlaufen.

5. Zerstäubungsvorrichtung nach einem oder mehreren der vorhergehenden Ansprüche, weiter **gekennzeichnet,** daß der aus ferromagnetischem Werkstoff gebildete Einsatz (10, 14) eine im wesentliche flache kreisringzylindrische Form aufweist oder als ein etwa flacher ovaler Ring ausgebildet ist, wobei in die dem Target (3) zugewandte Fläche des aus ferromagnetischem Werkstoff gebildeten Einsatzes (10, 14) eine Nut oder eine grabenförmige Vertiefung (11, 16) eingeformt ist, die sich parallel den beiden Permanentmagnetreihen (7, 8) erstreckt und wobei die die Nut (11, 16) radial begrenzenden beiden Teilflächen (10b, 10c bzw. 14b, 14c) des Einsatzes (10, 14) dichtend an einer Platte oder einem Folienzuschnitt (4) anliegen, die zwischen dem Target (3) und dem Einsatz (10, 14) eingelegt ist und die zusammen mit der Nut (11, 16) einen Kühlmittelkanal begrenzt.

## Claims

1. Sputtering device with magnetic amplification by a permanent magnet arrangement which is arranged on the side of a target facing away from the sputtering surface of this target and which generates a magnetic field, the force lines of which run above the sputtering surface and penetrate the latter, with a cathode which is formed at least partially by the sputtering surface, and with an anode arranged at a distance in front of the cathode for generating an electric field, wherein the permanent magnet arrangement is formed of two circular or oval, closed and coaxial rows (7, 8) of individual magnets (5, 5', ..., 6, 6', ...) which are connected to one another via a yoke (9, 15), wherein an insert (10, 14) made of ferromagnetic material is provided, **characterised in that** the insert (10, 14) is U-shaped or essentially U-shaped in cross section, is provided between the two rows (7, 8) of permanent magnets and is adapted in terms of its configuration to the yoke (9), wherein its rear surface which faces away from the target (3) bears against the surface of the magnetic yoke (9) which faces towards the target (3) and is delimited by the rows (7, 8) of permanent magnets, wherein the two legs of the insert (10, 14) respectively extend at a distance (a, b) from the rows (7, 8) of permanent magnets in the direction towards the target (3).

2. Sputtering device according to the preamble of claim 1, **characterised in that** the surface of the target (3) which faces away from the rows (7, 8) of permanent magnets is formed of two partial surfaces (3a, 3b) which extend at an angle to one another, wherein the edge (3c) formed by the two partial surfaces (3a, 3b) with respect to one another runs parallel to the rows (7, 8) of permanent magnets (5, 5', ..., 6, 6', ...), and wherein the insert (10, 14) is placed between the magnetic yoke (9, 15) and the surface of the target (3) which faces towards the magnetic yoke (9, 15).

3. Sputtering device according to claims 1 and/or 2, further **characterised in that** the surface of the insert (14) which faces towards the radially inner row (7) of permanent magnets is oriented perpendicular to the plane of the target, and the surface of the insert (14) which faces towards the radially outer row (8) of permanent magnets is configured as a surface (14a) which is inclined with respect to the plane of the yoke (15).

4. Sputtering device according to one of claims 1 to 3, further **characterised in that** the individual permanent magnets (5, 5', ..., 6, 6', ...) of the rows (7, 8) of permanent magnets are formed as straight prisms, preferably as cubes or cuboids, the bottom edges and side edges of which run in an inclined manner with respect to the plane of the target.

5. Sputtering device according to one or more of the preceding claims, further **characterised in that** the insert (10, 14) made of ferromagnetic material has an essentially flat circular-cylindrical shape or is designed as an approximately flat oval ring, wherein a groove or a trench-like depression (11, 16) which extends parallel to the two rows (7, 8) of permanent magnets is formed in the surface of the insert (10, 14) made of ferromagnetic material which faces towards the target (3), and wherein the two partial surfaces (10b, 10c or 14b, 14c) of the insert (10, 14) which radially delimit the groove (11, 16) bear in a sealing manner against a plate or a foil section (4) which is placed between the target (3) and the insert (10, 14) and which, together with the groove (11, 16), delimits a coolant channel.

## Revendications

1. Dispositif de pulvérisation à renforcement magnétique par un ensemble d'aimants permanents, qui est disposé sur la face d'une cible opposée à la surface de pulvérisation de cette cible et qui produit un champ magnétique dont les lignes de force passent au-dessus de la surface de pulvérisation et pénètrent dans celle-ci, avec une cathode, qui est formée au moins en partie par la surface de pulvérisation, et une anode disposée à distance devant la cathode pour produire un champ électrique, dans lequel l'ensemble d'aimants permanents est formé par deux rangées (7, 8) d'aimants individuels (5, 5', ... 6, 6', ...) circulaires ou ovales, chacune fermée sur elle-même et disposées coaxialement l'une par rapport à l'autre, et qui sont reliées l'une à l'autre par l'intermédiaire d'une culasse (9, 15) dans laquelle est prévu un insert (10, 14) fait d'un matériau ferromagnétique, **caractérisé en ce que** l'insert (10, 14) est prévu avec une section transversale en forme de U ou essentiellement en forme de U entre les deux rangées d'aimants permanents (7, 8) et a une configuration adaptée à la culasse (9), la face arrière de l'insert opposée à la cible (3) étant appuyée contre la face de la culasse magnétique (9) tournée vers la cible (3) et délimitée par les rangées d'aimants permanents (7, 8), les deux branches de l'insert (10, 14) se trouvant chacune à une certaine distance (a, b) des rangées d'aimants permanents (7, 8) en direction de la cible (3).

2. Dispositif de pulvérisation selon le préambule de la revendication 1, **caractérisé en ce que** la surface de la cible (3) opposée aux rangées d'aimants permanents (7, 8) est formée de deux surfaces partielles (3a, 3b) disposées à un certain angle l'une par rapport à l'autre, dans lequel l'arête (3c) formée par les deux surfaces partielles (3a, 3b) s'étend parallèlement aux rangées (7, 8) d'aimants permanents (5, 5', ... 6, 6', ...), et dans lequel l'insert (10, 14) est placé entre la culasse magnétique (9, 15) et la surface de la cible (3) tournée vers la culasse magnétique (9, 15).

3. Dispositif de pulvérisation selon les revendications 1 et/ou 2, **caractérisé en outre en ce que** la surface de l'insert (14), tournée vers la rangée d'aimants permanents (7) située radialement à l'intérieur, s'étend perpendiculairement au plan de la cible, et la surface de l'insert (14) tournée vers la rangée d'aimants permanents (8) située radialement à l'extérieur est conçue sous forme de surface (14a) inclinée par rapport au plan de la culasse (15).

4. Dispositif de pulvérisation selon l'une quelconque des revendications 1 à 3, **caractérisé en outre en ce que** les aimants permanents individuels (5, 5', ..., 6, 6', ...) des rangées d'aimants permanents (7, 8) sont conçus sous forme de prismes droits, de préférence sous forme de cubes ou de parallélépipèdes dont les arêtes de base et les arêtes latérales sont inclinées par rapport à la surface de la cible.

5. Dispositif de pulvérisation selon une ou plusieurs des revendications précédentes, **caractérisé en outre en ce que** l'insert (10, 14) fait d'un matériau ferromagnétique a une forme d'anneau cylindrique essentiellement plane ou est conçu sous forme d'anneau ovale à peu près plat, dans lequel une rainure ou une cavité en forme de tranchée (11, 16) est formée dans la surface de l'insert (10, 14) fait d'un matériau ferromagnétique tournée vers la cible (3), laquelle rainure s'étend parallèlement aux deux rangées d'aimants permanents (7, 8), et dans lequel les deux surfaces partielles (lOb, 10c ou 14b, 14c) de l'insert (10, 14) délimitant radialement la rainure (11, 16) sont appuyées de manière hermétique contre une plaque ou une feuille découpée (4) qui est placée entre la cible (3) et l'insert (10, 14) et qui, conjointement avec la rainure (11, 16), délimite un canal pour fluide de refroidissement.
